# EUROPÄISCHE PATENTSCHRIFT

(11) **EP 1 212 833 B1**
(45) Veröffentlichungstag und Bekanntmachung des Hinweises auf die Patenterteilung: **29.10.2003**
(21) Anmeldenummer: 00960358.0
(22) Anmeldetag: 23.08.2000
(51) Int. Cl.: H03K 17/00, H03K 17/16

(54) **TREIBERSCHALTUNG UND VERFAHREN ZUM BETREIBEN EINER TREIBERSCHALTUNG**
DRIVER CIRCUIT AND METHOD FOR OPERATING A DRIVER CIRCUIT
CIRCUIT D'EXCITATION ET PROCEDE POUR FAIRE FONCTIONNER UN CIRCUIT D'EXCITATION

(30) Priorität: 25.08.1999 DE 19940356
(43) Veröffentlichungstag der Anmeldung: 12.06.2002
(73) Patentinhaber: Infineon Technologies AG, 81669 München (DE)
(72) Erfinder: PAULUS, Christian, D-81479 München (DE); KLEIN, Ralf, D-81825 München (DE)
(74) Vertreter: Viering, Jentschura & Partner
(86) Internationale Anmeldenummer: DE0002875
(87) Internationale Veröffentlichungsnummer: WO01015322

(56) Entgegenhaltungen:
- WO-A-99/26340
- DE-A- 19 916 437
- US-A- 4 682 050
- US-A- 5 537 067
- US-A- 5 872 473
- US-A- 5 973 512

## Beschreibung

Die vorliegende Erfindung betrifft generell eine Treiberschaltung sowie ein Verfahren zum Betreiben einer solchen Treiberschaltung.

Treiberschaltungen werden in der integrierten digitalen Schaltungstechnik auf vielfältige Weise eingesetzt, beispielsweise als Treiber für Leitungen, Busse von integrierten Schaltungen oder dergleichen.

In den letzten Jahren sind die Anforderungen an elektronische Bauelemente und damit auch an die Treiberschaltungen, insbesondere in schnell getakteten elektronischen Systemen, rapide angestiegen. Eine dieser gestiegenen Anforderungen betrifft beispielsweise die elektromagnetische Verträglichkeit (EMV).

Integrierte, digitale Schaltkreise sind in der Regel über leitende Verbindungen mit peripheren Einrichtungen, Leistungsquellen und dergleichen verbunden. Dadurch ergeben sich unter anderem Parasitärkapazitäten, die zu nachteiligen Signalveränderungen führen. Externe Lasten, die Parasitärkapazitäten und auch die Treibertransistoren selbst bilden ein elektronisches Netzwerk, in dem Resonanzeffekte, Reflektionen und dergleichen auftreten können. Diese erzeugen transiente Signale, die von ihrer vorgesehenen Größe und Form abweichen und ihre endgültigen Spannungszustände übertreffen oder untertreffen können. Aufgrund der dicht gepackten Bauweise auf Chips können derartige transiente Signale nicht nur die eigenen Signalleitungen selbst, sondern auch Signalleitungen benachbarter elektronischer Bauelemente negativ beeinflussen.

Aufgrund der zunehmenden Anforderungen entsteht die Notwendigkeit, elektronische Bauelemente, entsprechende Treiberschaltungen und dergleichen derart zu verbessern, so daß diese Nachteile vermieden werden können.

In der US-A-5,537,067 ist beispielsweise eine Treiberschaltung beschrieben, die betrieben werden kann, um die Anstiegszeiten (rise time) und Abfallzeiten (fall time) von an eine Last gelieferten Signalen zu regeln. Diese Treiberschaltung weist einen ersten Inverter mit einem PMOS-Transistor und einem NMOS-Transistor sowie einem Widerstand auf. Ein zweiter Inverter weist einen PMOS-Transistor und einen NMOS-Transistor auf. Der Widerstand sowie zusätzlich vorgesehene Kondensatoren erhöhen die Übergangszeiten des Ausgangs-Treibersignals, um die elektromagnetische Strahlung zu kontrollieren, die durch kurze Übergangszeiten des Ausgangssignals hervorgerufen wird.

Aus WO 99/26340 ist ein Ausgabe-Puffer bekannt, bei dem das Verhalten des Ausgabesignals unabhängig von der von dem Puffer wahrgenommenen kapazitiven Last ist. Der Schaltkreis enthält einen kapazitiven Rückkopplungspfad von dem Ausgabeknoten zu der Verschaltung, welche die Ausgabetransistoren treibt.

US 5,872,473 offenbart einen Schaltkreis mit einem Schalt-Abschnitt, eingerichtet zum Erzeugen eines ersten und zweiten Steuersignals. Ein weiterer Abschnitt des Schaltkreises empfängt die ersten und zweiten Signale zum Erzeugen einer Ausgabe. Zwischen dem Schalt-Abschnitt und dem weiteren Abschnitt kann ein Kondensator vorgesehen sein, zum Koppeln der Ausgabe mit dem Schalt-Abschnitt.

Aufgabe der vorliegenden Erfindung ist die Bereitstellung einer verbesserten Treiberschaltung sowie eines verbesserten Verfahrens zum Betreiben einer Treiberschaltung, mit der/dem insbesondere die elektromagnetische Verträglichkeit elektronischer Bauelemente verbessert werden kann.

Diese Aufgabe wird gemäß dem ersten Aspekt der Erfindung durch eine Treiberschaltung gemäß dem unabhängigen Patentanspruch 1 gelöst. Vorteilhafte Weiterbildungen der erfindungsgemäßen Treiberschaltung ergeben sich aus den Unteransprüchen.

Erfindungsgemäß wird eine Treiberschaltung bereitgestellt, mit wenigstens einem Eingangsknoten für ein Eingangssignal und wenigstens einem Ausgangsknoten für ein Ausgangssignal, mit einem oder mehreren, vorzugsweise zwei Teiltreibern und mit einer Rückkopplungsschaltung, die eine oder mehrere Auswerteschaltungen und einen oder mehrere Rückkopplungskondensatoren aufweist, wobei die Auswerteschaltung(en) mit dem/den Teiltreiber(n) verbunden ist/sind und wobei der/die Rückkopplungskondensator(en) jeweils zwischen einem der Treiberschaltung und einem Eingangsknoten einer Auswerteschaltung vorgesehen ist/sind. Die wenigstens eine Auswerteschaltung weist eine mit dem Eingangsknoten der Auswerteschaltung gekoppelte erste Inverterstufe sowie eine mit der ersten Inverterstufe in Serie geschaltete zweite Inverterstufe auf, wobei die erste Inverterstufe mit dem Eingangsknoten kurzgeschlossen ist.

Durch eine solche Treiberschaltung läßt sich eine große Verbesserung der elektromagnetischen Verträglichkeit elektronischer Bauelemente, insbesondere von integrierten Schaltungen erreichen.

Der Grundgedanke der erfindungsgemäßen Treiberschaltung liegt darin, daß zunächst ein möglichst oberwellenarmes Signal erzeugt werden kann, das an eine Last geliefert wird. Beispielsweise kann es sich bei dem Signal um einen Strom handeln, der während der Schaltflanken beispielsweise als Lade-/Entladestrom an eine Lastkapazität geliefert werden kann. Da das Störspektrum einer Treiberschaltung vom zeitlichen Verlauf des Stroms abhängt, der die Lastkapazität lädt, ist als oberwellenarmer Strom insbesondere ein sin²-förmiger Strom von Vorteil, der ein günstiges Störspektrum hat. Die Erzeugung des oberwellenarmen Stroms erfolgt vorzugsweise in dem wenigstens einen Teiltreiber. Dies wird im weiteren Verlauf der Beschreibung noch näher erläutert.

Üblicherweise hängen die Anstiegszeiten (rise time) und Abfallzeiten (fall time) einer Treiberschaltung - und damit auch der zeitliche Stromverlauf - von der Größe der Last beziehungsweise der Lastkapazität ab. Insbesondere bei kleinen Lasten liegt ein großes Störpotential vor, da ein ungeregelter Treiber diese dann zu schnell umlädt.

Deshalb soll von der Treiberschaltung zusätzlich eine von der aktuellen Lastsituation unabhängige Flankensteilheit des an die Last gelieferten Signals (aus der Treiberschaltung ausgekoppeltes Ausgangssignal) eingestellt werden können. Die Einstellung der lastunabhängigen Flankensteilheit erfolgt über die Rückkopplungsschaltung, in der jeweils eine aktuelle Flankensteilheit gemessen und ausgewertet wird. Aufgrund der Auswertungsergebnisse kann die Treiberstärke in dem wenigstens einen Teiltreiber beispielsweise in Echtzeit angepaßt werden. Es ist jedoch auch möglich, daß die Treiberstärke sukzessive oder dergleichen angepaßt werden kann.

Die Messung der aktuellen Flankensteilheit des Ausgangssignals erfolgt über den wenigstens einen Rückkopplungskondensator. Hier wird ein Verschiebestrom erzeugt, der in die wenigstens eine Auswerteschaltung eingekoppelt und dort ausgewertet wird. Die Auswertung kann beispielsweise derart erfolgen, daß der gemessene Verschiebestrom mit entsprechenden Referenzstromwerten verglichen wird. Anschließend werden die ausgewerteten Ergebnisse als Steuersignale an den wenigstens einen Teiltreiber weitergeleitet, wo dessen Treiberstärke entsprechend angepaßt beziehungsweise nachgeregelt werden kann. Auf diese Weise wird erreicht, daß im Rückkopplungskondensator immer der gleiche Verschiebestrom auftritt. Beispiele für den Aufbau und die Funktionsweise der Rückkopplungsschaltung werden im weiteren Verlauf der Beschreibung näher erläutert.

Durch die erfindungsgemäße Treiberschaltung wird es somit möglich, die Ausgangscharakteristik der Treiberschaltung direkt messen zu können, die Meßergebnisse auszuwerten und in Abhängigkeit der ausgewerteten Ergebnisse eine Veränderung und Anpassung der Treiberstärke herbeiführen zu können. Dadurch können von der Ausgangslast weitgehend unabhängige Anstiegszeiten (rise time) und Abfallzeiten (fall time) erreicht werden. Das bedeutet insbesondere, daß auch temporäre Störungen, wie beispielsweise das gegenphasige Schalten benachbarter, kapazitiv gekoppelter Leitungen oder dergleichen, die Flankensteilheit nicht beeinflussen.

Bei der erfindungsgemäßen Treiberschaltung ist es nicht erforderlich, daß die Größe der nachgeschalteten Last bekannt ist. Wichtig ist lediglich, daß die Last kleiner als eine maximal zulässige Last ist.

Über die Treiberschaltung wird ermöglicht, daß ein Eingangssignal, beispielsweise ein binäres Eingangssignal, über den wenigstens einen Eingangsknoten in diese eingekoppelt werden kann, wobei das Signal in der Treiberschaltung umgewandelt und über den wenigstens einen Ausgangsknoten an eine Last, beispielsweise eine Lastkapazität abgegeben wird.

Die Treiberschaltung weist wenigstens einen Teiltreiber auf, der als sogenannter Pull-Up-Treiber (ein Treiber für die positive Flanke) und/oder als Pull-Down-Treiber (ein Treiber für die negative Flanke) ausgebildet sein kann.

Nachfolgend wird nun zunächst der konstruktive Aufbau einer erfindungsgemäßen Treiberschaltung beschrieben. Dabei ist jedoch selbstverständlich, daß die Erfindung nicht auf die genannten Beispiele beschränkt ist.

Die Treiberschaltung kann einen oder mehrere Teiltreiber aufweisen. Vorteilhaft kann die Treiberschaltung zwei Teiltreiber aufweisen, die beispielsweise als Pull-Up-Treiber und als Pull-Down-Treiber ausgebildet sein können.

Der wenigstens eine Teiltreiber ist mit wenigstens einem Ausgangsknoten verbunden, der ebenfalls mit einer Last verbunden ist. Über den Ausgangsknoten ist der wenigstens eine Teiltreiber auch mit der wenigstens einen Auswerteschaltung der Rückkopplungseinrichtung verbunden. In dieser Verbindungsleitung ist wenigstens ein Rückkopplungskondensator vorgesehen.

Vorzugsweise kann der wenigstens eine Eingangsknoten für das Eingangssignal mit dem wenigstens einen Teiltreiber verbunden sein. Über diese Verbindung kann in den wenigstens einen Teiltreiber ein Signal eingekoppelt werden aufgrund dessen im Teiltreiber ermittelt werden kann, ob dieser aktiviert werden muß. Der Wert für die Größe des nachzustellenden oder zu ändernden Werts für die Treiberstärke wird in dem/den Teiltreiber(n) über die Verbindung zwischen Teiltreiber und Auswerteschaltung eingekoppelt.

Weiterhin kann der wenigstens eine Eingangsknoten für das Eingangssignal mit der wenigstens einen Auswerteschaltung verbunden sein. Über diese Verbindung ist es beispielsweise möglich, daß die Rückkopplungsschaltung zeitweilig stillgelegt werden kann, wenn keine Transienten zu erwarten sind. Dies führt zu einer Reduzierung der Verlustleistung.

In weiterer Ausgestaltung können zwei oder mehr Teiltreiber und zwei oder mehr Auswerteschaltungen vorgesehen sein, wobei jeder Teiltreiber mit einer Auswerteschaltung verbunden ist.

Bei einer solchen Ausgestaltungsform sind vorteilhaft ebenfalls zwei oder mehr Rückkopplungskondensatoren vorgesehen, wobei jeder Rückkopplungskondensator zwischen einem Ausgangsknoten der Treiberschaltung und einem Eingangsknoten einer Auswerteschaltung vorgesehen ist.

Vorteilhaft kann der wenigstens eine Ausgangsknoten mit einer Lastkapazität verbunden oder verbindbar sein. Bei der Lastkapazität kann es sich zum einen um die Kapazität einer mit der Treiberschaltung verbundenen Last, beispielsweise einem elektronischen Bauelement handeln. Weiterhin können unter den Begriff der Lastkapazität auch Parasitärkapazitäten oder dergleichen zusammengefaßt werden, die am Ausgang der Treiberschaltung oder in der Verbindung der Treiberschaltung mit der jeweiligen Last auftreten.

Vorzugsweise sind der oder die Eingangsknoten der Auswerteschaltung(en) niederimpedant ausgebildet. Auf diese Weise wird gewährleistet, daß während einer Transienten ein kleiner Verschiebestrom über den Rückkopplungskondensator fließen kann, der dann in die Auswerteeinrichtung eingekoppelt wird. Dieser Verschiebestrom wird von der Rückkopplungsschaltung gemessen und ausgewertet.

Vorzugsweise kann der wenigstens eine Teiltreiber einen oder mehrere Transistoren aufweisen. Im einfachsten Fall kann der Teiltreiber einen einzigen Transistor aufweisen. Es sind jedoch auch komplexere Ausgestaltungsformen denkbar, so daß die Erfindung nicht auf eine bestimmte Anzahl von Transistoren beschränkt ist.

Einer der Transistoren kann beispielsweise als der eigentliche Treibertransistor ausgebildet sein. Weiterhin kann ein zusätzlicher Transistor vorgesehen sein, der als Stromquelle arbeitet. Je nach Bedarf kann noch ein zusätzlicher Transistor vorgesehen sein, der als Schalter fungiert.

Wenn die Treiberschaltung zwei Teiltreiber aufweist, die in der vorstehend genannten Weise ausgebildet sind, kann ein im wesentlichen oberwellenarmer, insbesondere sin²-förmiger Strom erzeugt werden. Dies erfolgt über die Auswahl einer geeigneten Dimensionierung der eigentlichen Treibertransistoren sowie der als Stromquelle fungierenden Transistoren. Die Ausführung einiger der Transistoren als Stromquellen (Vortreibertransistoren) und das gezielte Ausnutzen der parasitären Gate-Drain-Kapazitäten der eigentlichen Treibertransistoren ermöglicht eine Formung des Laststromverlaufs in weiten Grenzen.

Vorzugsweise kann in dem wenigstens einen Teiltreiber jeweils wenigstens ein Steuertransistor vorgesehen sein, der jeweils mit einer Auswerteschaltung verbunden ist. Das von dem Rückkopplungskondensator gemessene und in der Auswerteschaltung ausgewertete Signal wird als Ausgangssignal aus der Auswerteschaltung ausgekoppelt und dient zur Ansteuerung des oder der Steuertransistoren, der/die die Stärke des als Vortreiber fungierenden Transistors beziehungsweise der Transistoren entsprechend verändert, beispielsweise reduziert.

In weiterer Ausgestaltung kann die wenigstens eine Auswerteschaltung als Verstärkerschaltung mit einem oder mehreren Transistoren ausgebildet sein. In der Verstärkerschaltung wird der über den Eingangsknoten eingekoppelte Verschiebestrom derart verstärkt, daß er zur Ansteuerung des wenigstens einen Teiltreibers, insbesondere des im Teiltreiber vorgesehenen Steuertransistors verwendet werden kann. Der Verstärker besteht aus einem oder mehreren Transistoren, wobei die Anzahl der Transistoren je nach Anwendungsfall und Verstärkerleistung variieren kann.

Vorteilhaft kann der wenigstens eine Rückkopplungskondensator als linearer Kondensator ausgebildet sein. Es ist jedoch auch möglich, daß der wenigstens eine Rückkopplungskondensator als nicht-linearer Kondensator ausgebildet ist.

In einer vorteilhaften Ausgestaltung ist der nicht-lineare Kondensator aus wenigstens einem PMOS-Transistor und/oder wenigstens einem NMOS-Transistor gebildet. In einer solchen Ausgestaltung kann der Kondensator beispielsweise aus jeweils einem NMOS-Transistor und einem PMOS-Transistor bestehen, wobei die beiden Transistoren parallel geschaltet sind. Es sind jedoch auch andere Ausgestaltungsformen denkbar, so daß die Erfindung nicht auf das beschriebene Beispiel beschränkt ist.

Ein aus NMOS- und PMOS-Transistoren aufgebauter nicht-linearer Kondensator weist eine spannungsabhängige Kapazität auf, so daß bei entsprechender Wahl der Längen und Weiten Wp, Lp, Wn, Ln der Transistoren drei spannungsabhängige Kapazitätswerte realisiert werden können. Dadurch kann eine zusätzliche gezielte Formung der Ausgangskennlinie der Treiberschaltung vorgenommen werden. In der Auswerteschaltung wird der Verschiebestrom des Rückkopplungskondensators mit einem Referenzstrom verglichen. Aufgrund der Auswertung wird über ein Steuersignal die Treiberstärke eingestellt, so daß im Rückkopplungskondensator immer der gleiche Verschiebestrom auftritt. Bei einem nicht-linearen Kondensator wird demzufolge bei hohen Kapazitätswerten die Flankensteilheit reduziert und bei kleinen Kapazitätswerten erhöht. So kann erreicht werden, daß in einer Lastkapazität zunächst ein kleiner Strom fließt, danach ein größerer und dann wieder ein kleinerer.

Gemäß dem zweiten Aspekt der Erfindung wird ein Verfahren bereitgestellt, bei dem eine wie vorstehend beschriebene erfindungsgemäße Treiberschaltung betrieben wird, wobei das Verfahren erfindungsgemäß dadurch gekennzeichnet ist, daß in der Treiberschaltung ein oberwellenarmer Strom erzeugt und an eine Last geliefert wird und daß in der Treiberschaltung eine von der aktuellen Lastsituation unabhängige Flankensteilheit eingestellt wird.

Durch das erfindungsgemäße Verfahren wird erreicht, daß der Last zum einen ein Strom beziehungsweise ein Signal mit EMVvorteilhaften Eigenschaften geliefert wird. Zum anderen wird auch eine von der aktuellen Lastsituation unabhängige Flankensteilheit erreicht, was die EMV speziell bei geringer Last deutlich verbessert. Zu den Vorteilen, Wirkungen, Effekten sowie der Funktionsweise des erfindungsgemäßen Verfahrens wird ebenfalls auf die vorstehenden Ausführungen zur erfindungsgemäßen Treiberschaltung vollinhaltlich Bezug genommen und hiermit verwiesen.

Bevorzugte Ausführungsformen des Verfahrens ergeben sich aus den Unteransprüchen.

Vorteilhaft kann ein sin²-förmiger Strom an die Last geliefert werden.

Zur Einstellung der lastunabhängigen Flankensteilheit kann vorzugsweise die Ausgangscharakteristik der Treiberschaltung von der Rückkopplungsschaltung gemessen und in dieser ausgewertet werden, wobei die Treiberstärke des wenigstens einen Teiltreibers aufgrund der Auswertungsergebnisse geregelt wird.

Dabei kann die aktuelle Flankensteilheit von dem wenigstens einen Rückkopplungskondensator gemessen und der gemessene Wert in die wenigstens eine Auswerteschaltung eingekoppelt und ausgewertet werden. In der Auswerteschaltung wird dann ein Ausgangssignal erzeugt, über das wenigstens ein Steuertransistor gesteuert wird, der zur Regelung der Treiberstärke in dem wenigstens einen Teiltreiber vorgesehen ist.

In einer besonders vorteilhaften Verwendung kann die erfindungsgemäße Treiberschaltung und/oder das erfindungsgemäße Verfahren zur Verbesserung der elektromagnetischen Verträglichkeit von elektronischen Bauelementen, insbesondere von integrierten Schaltungen eingesetzt werden.

Die Erfindung wird nun anhand von Ausführungsbeispielen unter Bezugnahme auf die beiliegende Zeichnung näher erläutert. Es zeigen:
- Figur 1: eine schematische Ansicht einer ersten Ausführungsform der erfindungsgemäßen Treiberschaltung;
- Figur 2: eine schematische Ansicht einer zweiten Ausführungsform der erfindungsgemäßen Treiberschaltung;
- Figur 3: ein Schaltbild der Treiberschaltung gemäß Fig.1;
- Figur 4: ein Ersatzschaltbild eines Rückkopplungskondensators;
- Figur 5: ein Diagramm, in dem der Kapazitätsverlauf des Rückkopplungskondensators gemäß Figur 4 in Abhängigkeit von der angelegten Spannung dargestellt ist;
- Figur 6: ein Diagramm, das den Spannungsverlauf einer Treiberschaltung mit Rückkopplungsschaltung bei einer hohen und einer geringen Last darstellt; und
- Figur 7: ein Diagramm, das den Spannungsverlauf einer Treiberschaltung ohne Rückkopplungsschaltung bei einer hohen und einer geringen Last darstellt.

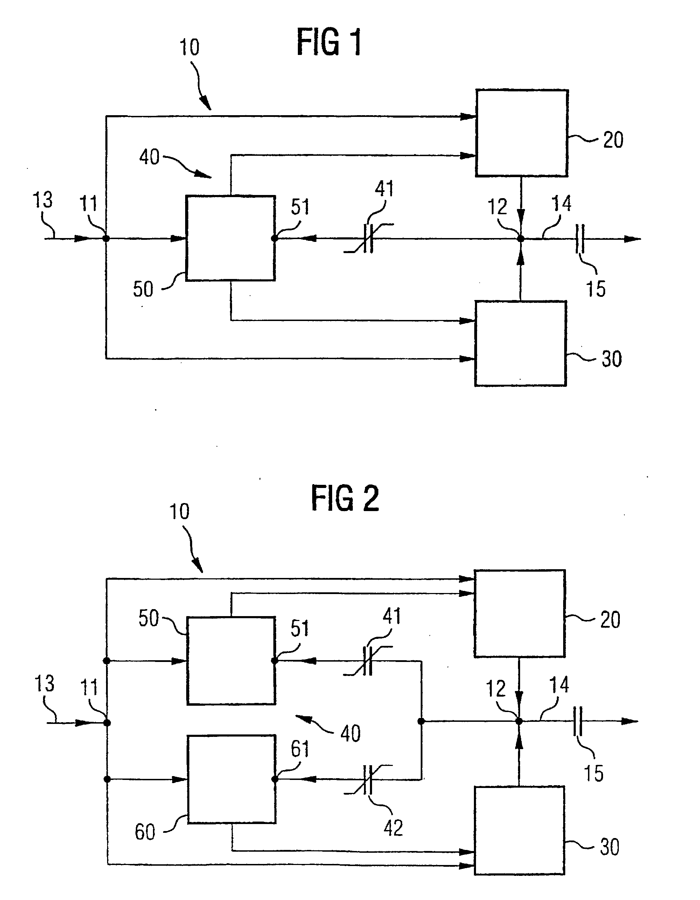

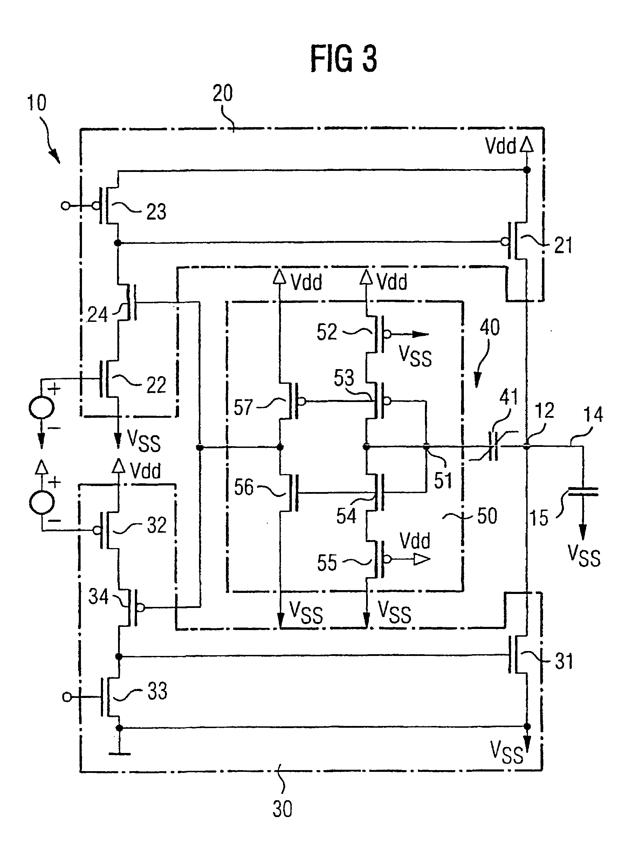

In den Figuren 1 und 2 werden zunächst zwei unterschiedliche Ausführungsformen einer erfindungsgemäßen Treiberschaltung 10 in genereller Konfiguration dargestellt, während in Figur 3 ein detailliertes Schaltbild einer Treiberschaltung 10 gemäß Figur 1 dargestellt ist, in dem die einzelnen Bauelemente spezifiziert ausgebildet sind.

Die Treiberschaltung 10 wird in der digitalen CMOS-Schaltungstechnik für Leitungen, Busse oder dergleichen verwendet.

Die Treiberschaltung 10 gemäß Figur 1 weist einen Eingangsknoten 11 auf, in den ein Eingangssignal 13, beispielsweise ein binäres Signal, eingekoppelt wird. In der Treiberschaltung 10 wird das Eingangssignal 13 umgewandelt und als Ausgangssignal 14 über einen Ausgangsknoten 12 ausgekoppelt und einer Last, im vorliegenden Fall einer Lastkapazität 15 zur Verfügung gestellt.

Die Treiberschaltung 10 weist zwei Teiltreiber 20, 30 auf, nämlich einen Pull-Up-Treiber 20 und einen Pull-Down-Treiber 30. Die beiden Teiltreiber 20, 30 sind mit dem Eingangsknoten 11 verbunden.

Weiterhin ist eine Rückkopplungsschaltung 40 vorgesehen, die eine Auswerteschaltung 50 und einen Rückkopplungskondensator 41 darstellt.

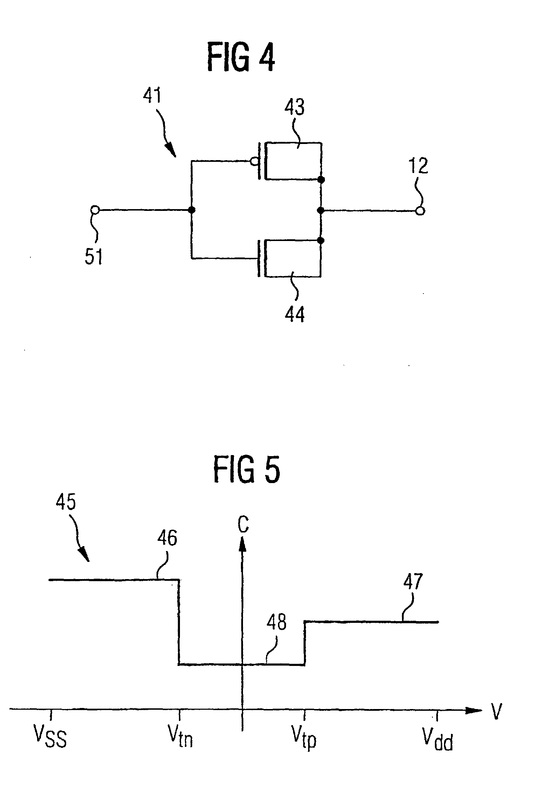

Wie sich aus Figur 4 ergibt, ist der Rückkopplungskondensator 41 als nicht-linearer Kondensator ausgebildet, der einen PMOS-Transistor 43 und einen zu diesem parallel geschalteten NMOS-Transistor 44 aufweist. Allerdings kann der Rückkopplungskondensator 41 auch als linearer Kondensator oder als nicht-linearer Kondensator mit anderer Ausgestaltung ausgebildet sein. Der Rückkopplungskondensator 41 ist mit einem Eingangsknoten 51 der Auswerteschaltung 50 und dem Ausgangsknoten 12 der Treiberschaltung 10 verbunden.

In Figur 5 ist der qualitative Kapazitätsverlauf 45 des Rückkopplungskondensators 41 in der Ausbildung gemäß Figur 4 dargestellt. Dabei wird davon ausgegangen, daß der Eingangsknoten 51 auf etwa halbem Betriebsspannungspotential (Vdd/2) liegt. In den Bereichen 46, 47 höherer Kapazität befindet sich jeweils einer der Transistoren 43, 44 in Inversion. Im vorliegenden Ausführungsbeispiel befindet sich der PMOS-Transistor 43 im Bereich 46 des Kapazitätsverlaufs 45 in Inversion, während sich der NMOS-Transistor 44 im Bereich 47 in Inversion befindet. Im mittleren Bereich 48 des Kapazitätsverlaufs 45 liegt die Kondensatorspannung unterhalb der jeweiligen Schwellenspannungen Vtn und Vtp der Transistoren 43, 44, so daß lediglich Überlappkapazitäten zur Gesamtkapazität beitragen.

Der Eingangsknoten 51 der Auswerteschaltung 51 ist als niederimpedanter Knoten ausgebildet und liegt im vorliegenden Fall auf festem Potential. Die Auswerteschaltung 50, die als Verstärkerschaltung ausgebildet ist, ist weiterhin mit den Teiltreibern 20, 30 und dem Eingangsknoten 11 für das Eingangssignal 13 verbunden.

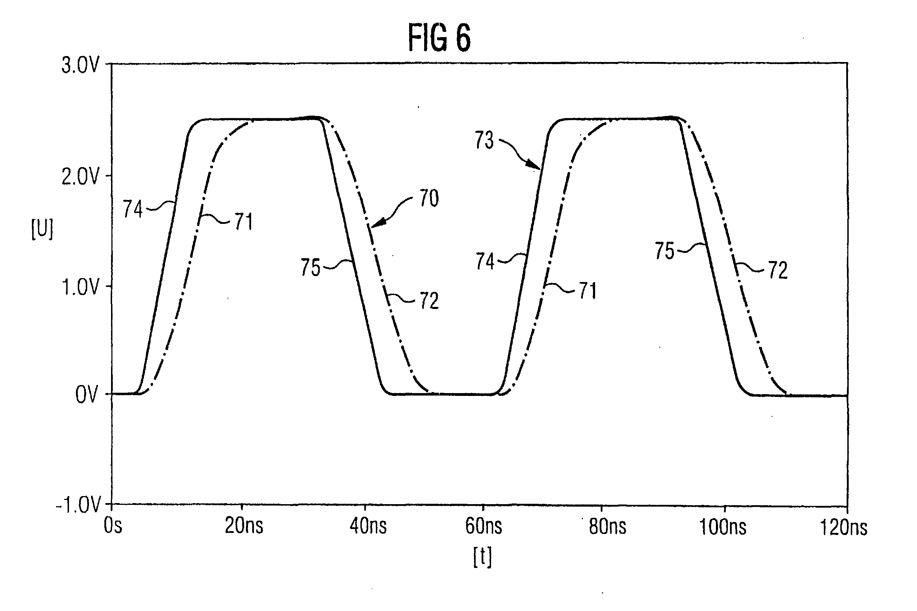

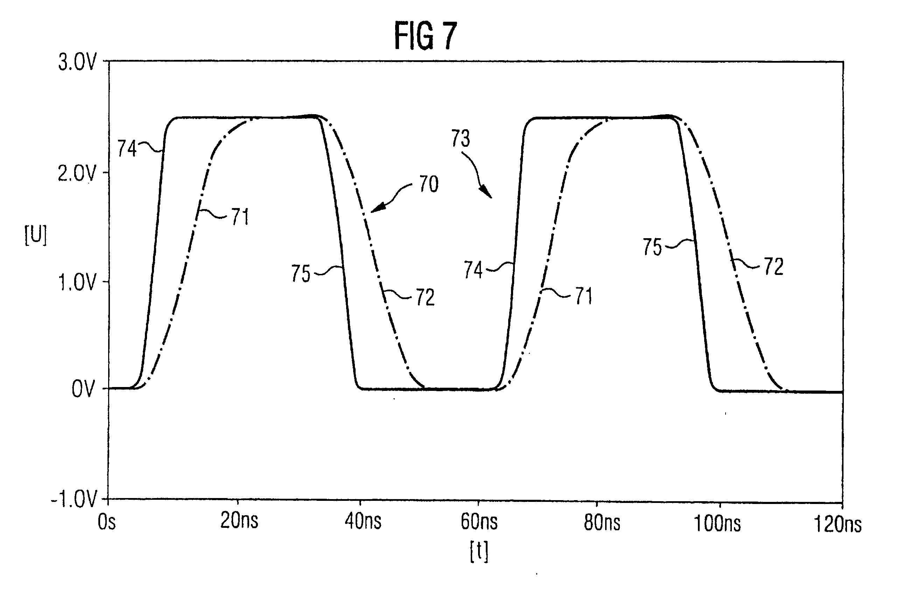

In Figur 3 ist ein detailliertes Schaltbild der Treiberschaltung 10 gemäß Figur 1 dargestellt. Dabei wurden die einzelnen Transistoren in bestimmter Weise dimensioniert, um eine anschließende Simulation zu ermöglichen, deren Resultate in den Figuren 6 und 7 dargestellt sind.

Wie aus Figur 3 ersichtlich ist, besteht die als Verstärkerschaltung ausgebildete Auswerteschaltung aus einer Reihe von Transistoren 52 bis 57, über die der gewünschte Verstärkungsgrad eingestellt wird. Die beiden Teiltreiber 20, 30 sind jeweils identisch aufgebaut und weisen jeweils einen Transistor 22, 32 auf, der als Stromquelle arbeitet und als sogenannter Vortreiber fungiert. Weiterhin ist jeweils ein eigentlicher Treibertransistor 21, 31 vorgesehen. Die Transistoren 21, 31 verfügen über eine große Weite, um die Treiberstärke realisieren zu können. Darüber hinaus verfügen beide Teiltreiber 20, 30 über einen durch Transistor 23, 33 ausgebildeten Schalter. Schließlich sind noch zwei Transistoren 24, 34 vorgesehen, die die Funktion von Steuertransistoren haben. Die Steuertransistoren 24, 34 sind mit der Verstärkerschaltung 50 verbunden.

Nachfolgend wird nun die Funktionsweise der Treiberschaltung 10 beschrieben.

Eine große Verbesserung der elektromagnetischen Verträglichkeit (EMV) integrierter Schaltungen ist zu erreichen, wenn die Treiberschaltung 10 für Pads, Busse oder dergleichen während der Schaltflanken einen Lade-/ Entladestrom an die Lastkapazität 15 liefert, der möglichst oberwellenarm, insbesondere sin²-förmig ist. Ferner soll die Treiberschaltung 10 eine von der aktuellen Lastsituation unabhängige Flankensteilheit haben, um die EMV speziell für kleine Lasten weiter zu verbessern.

Die in den Figuren 1 und 3 dargestellte Treiberschaltung 10 vereint die Eigenschaft, einen sin²-förmigen Strom zu liefern, mit einer von der aktuellen Last 15 unabhängigen Flankensteilheit.

Um den sin²-förmigen Strom zu erhalten, arbeiten die beiden Transistoren 22, 32 als Stromquellen. Die Ausführung der Vortreiber-Transistoren 22, 32 als Stromquellen und das gezielte Ausnutzen der parasitären Gate-Drain-Kapazität der Treibertransistoren 21, 31 ermöglicht eine EMV günstige Formung des Ladestromverlaufs (sin²-förmig).

Die Lastunabhängigkeit wird erreicht, indem die Flankensteilheit gemessen und dementsprechend die Treiberstärke in Echtzeit oder sukzessive angepaßt wird. Zur Messung dient der Rückkopplungskondensator 41, der zwischen dem Ausgangsknoten 12 der Treiberschaltung 10 und dem Eingangsknoten 51 der Verstärkerschaltung 50 geschaltet ist. Da der Eingangsknoten 51 als niederimpedanter Knoten ausgebildet ist, wird durch den Rückkopplungskondensator 41 ein kleiner Strom in die Verstärkerschaltung 50 eingekoppelt und dort ent-sprechend ausgewertet. Das Ausgangssignal der Verstärkerschaltung 50 dient zur Ansteuerung der Steuertransistoren 24, 34, die die Stärke der Vortreiber-Transistoren 22, 32 in geeigneter Weise nachregeln, beispielsweise reduzieren.

Insbesondere kann durch die Verwendung einer nicht-linearen Rückkopplungskapazität 41 eine gezielte Formung der Flanken der Ausgangskennlinie der Treiberschaltung vorgenommen werden. Der vom Rückkopplungskondensator 41 gelieferte Verschiebestrom wird in der Verstärkerschaltung 50 mit einem Referenzstrom verglichen. Über diese Auswertung wird die Treiberstärke in den beiden Teiltreibern 20, 30 derart eingestellt, daß im Rückkopplungskondensator 41 immer der gleiche Verschiebestrom auftritt. Der so realisierte Stromverlauf weist ein aus EMV-Sicht sehr günstiges Störverhalten auf.

Der Grundgedanke der erfindungsgemäßen Treiberschaltung 10 liegt somit darin, daß die Ausgangscharakteristik der Treiberschaltung 10 direkt gemessen und ausgewertet werden kann und daß dadurch eine entsprechende Anpassung der Treiberstärke vorgenommen werden kann. Dadurch werden von der Ausgangslast 15 weitgehend unabhängige Anstiegs- beziehungsweise Abfallzeiten (rise/fall times) erreicht. Das bedeutet insbesondere, daß auch temporäre Störungen, wie beispielsweise das gegenphasige Schalten benachbarter, kapazitiv gekoppelter Leitungen oder dergleichen, die Flankensteilheit nicht beeinflussen.

Die Möglichkeit, mit der erfindungsgemäßen Treiberschaltung 10 weitgehend lastunabhängige Anstiegs- und Abfallzeiten (rise/fall time) zu erreichen, ist im Hinblick auf die Figuren 6 und 7 dargestellt. Beide Figuren 6 und 7 zeigen jeweils Spannungsverläufe über die Zeit, die in einer gemäß der Figur 3 spezifizierten Treiberschaltung 10 simuliert wurden.

Figur 6 zeigt die Spannungsverläufe bei unterschiedlichen Lasten für eine Treiberschaltung 10 gemäß der vorliegenden Erfindung, die über eine Rückkopplungsschaltung 40 verfügt. Kurve 70 zeigt den Spannungsverlauf bei einer großen Lastkapazität von 50pF. Wie sich aus der Darstellung ergibt, weist der Spannungsverlauf Anstiegsflanken 71 und Abfallflanken 72 auf, wobei die Anstiegszeit (rise time) etwa 10ns beträgt. Die Abfallzeit (fall time) ist etwa gleich lang. Als Anstiegszeit (rise time) wird in diesem Ausführungsbeispiel derjenige Zeitraum verstanden, den ein Spannungssignal benötigt, um von 10% der Betriebsspannung (0.25V) auf 90% der Betriebsspannung (2.25V) zu gelangen. Umgekehrt wird als Abfallzeit (fall time) derjenige Zeitraum verstanden, den ein Spannungssignal benötigt, um von 90% der Betriebsspannung auf 10% der Betriebsspannung zu gelangen.

Kurve 73 zeigt den Spannungsverlauf bei einer kleinen Lastkapazität von 5pF. Wie aus Figur 6 ersichtlich ist, weist der Spannungsverlauf Anstiegsflanken 74 und Abfallflanken 75 auf, wobei die Anstiegszeit (rise time) und die Abfallzeit (fall time) bei etwa 8ns liegen.

Aus Figur 6 wird somit deutlich, daß durch Verwendung der erfindungsgemäßen Treiberschaltung 10 im wesentlichen lastunabhängige Spannungsverläufe erreicht werden können.

Im Gegensatz zu Figur 6 ist in Figur 7 der Spannungsverlauf bei einer großen und einer kleinen Last für eine Treiberschaltung 10 dargestellt, die über keine Rückkopplungsschaltung 40 verfügt, in der also nur ein in etwa sin²-förmiger Strom zur Verfügung gestellt wird, ohne eine lastunabhängige Flankensteilheit einzustellen.

Der Spannungsverlauf 70 mit den jeweiligen Anstiegsflanken 71 und Abfallflanken 72 entspricht wiederum einer großen Last von 50pF, während der Spannungsverlauf 73 mit den entsprechenden Anstiegsflanken 74 und Abfallflanken 75 einer kleinen Last von 5pF entspricht.

Wie aus Figur 7 deutlich zu ersehen ist, bestehen große Unterschiede in den Anstiegszeiten (rise times) und Abfallzeiten (fall times) der einzelnen Spannungsverläufe. Bei der großen Last von 50pF liegt die Anstiegszeit bei etwa 10ns, während die Anstiegszeit bei der kleinen Last nur etwa 4ns beträgt. Damit ist in diesem Fall eine Lastunabhängigkeit der einzelnen Spannungsverläufe und damit der Treiberschaltung 10 nicht gegeben.

In Figur 2 ist schließlich eine weitere Ausführungsform einer Treiberschaltung 10 dargestellt. Gleiche Bauelemente wie bei der Treiberschaltung 10 gemäß Figur 1 wurden mit identischen Bezugsziffern versehen.

Die Treiberschaltung 10 weist wiederum einen Eingangsknoten 11 für ein Eingangssignal 13 sowie einen Ausgangsknoten 12 für ein Ausgangssignal 14 auf, wobei das Ausgangssignal 14 am Ausgangsknoten 12 ausgekoppelt und einer Lastkapazität zur Verfügung gestellt wird. Die Treiberschaltung 10 weist wiederum einen Pull-Up-Teiltreiber 20 und einen Pull-Down-Teiltrieber 20 auf. Die beiden Teiltreiber 20, 30 sind mit dem Eingangsknoten 11 verbunden.

Im Gegensatz zu Figur 1 ist bei der Treiberschaltung 10 gemäß Figur 2 eine Rückkopplungsschaltung 40 vorgesehen, die zwei Auswerteschaltungen 50, 60 aufweist, wobei jeweils eine der Auswerteschaltungen 50, beziehungsweise 60 mit einem Teiltreiber 20, beziehungsweise 30 verbunden ist. Jede der Auswerteeinrichtungen 50, 60 ist mit dem Eingangsknoten 11 verbunden, über den das Eingangssignal 13 eingekoppelt werden kann.

Weiterhin sind insgesamt zwei Rückkopplungskondensatoren 41, 42 vorgesehen. Jeder dieser Kondensatoren 41, 42 ist in einer Verbindungsleitung angeordnet, die von dem Ausgangsknoten 12 zu einem jeweiligen Eingangsknoten 51, 61 der Auswerteeinrichtungen 50, 60 führt.

Der Aufbau der Teiltreiber 20, 30 entspricht dem Aufbau der Teiltreiber aus Figur 3. Ebenso entspricht die Funktionsweise der Treiberschaltung 10 der Funktionsweise der Treiberschaltung nach Figur 1 und 3, so daß zur Vermeidung von Wiederholungen auf eine erneute Beschreibung verzichtet und statt dessen auf die vorstehenden Ausführungen vollinhaltlich Bezug genommen und hiermit verwiesen wird.

## Patentansprüche

1. Treiberschaltung mit wenigstens einem Eingangsknoten (11) für ein Eingangssignal und wenigstens einem Ausgangsknoten (12) für ein Ausgangssignal mit einem oder mehreren, vorzugsweise zwei Teiltreibern (20,30) und mit einer Rückkopplungsschaltung (40), die eine oder mehrere Auswerteschaltungen (50,60) und einen oder mehrere Rückkopplungskondensatoren (41,42) aufweist, wobei die Auswerteschaltung(en) (50,60) mit dem/den Teiltreiber(n) (20,30) verbunden ist/sind und wobei der/die Rückkopplungskondensator (en) (41,42) jeweils zwischen einem Ausgangsknoten (12) der Treiberschaltung (10) und einem Eingangsknoten (51,61) einer Auswerteschaltung (50,60) vorgesehen ist/sind, wobei die wenigstens eine Auswerteschaltung (50,60) eine mit dem Eingangsknoten (51,61) der Auswerteschaltung (50,60) gekoppelte erste Inverterstufe (53,54) aufweist sowie eine mit der ersten Inverterstufe (53,54) in Serie geschaltete zweite Inverterstufe (56,57),
wobei die erste Inverterstufe (53,54) mit dem Eingangsknoten (51,61) kurzgeschlossen ist.

2. Treiberschaltung nach Anspruch 1,
wobei der wenigstens eine Eingangsknoten (11) für das Eingangssignal mit dem wenigstens einen Teiltreiber (20,30) verbunden ist.

3. Treiberschaltung nach Anspruch 1 oder 2,
wobei der wenigstens eine Eingangsknoten (11) für das Eingangssignal mit der wenigstens einen Auswerteschaltung (50,60) verbunden ist.

4. Treiberschaltung nach einem der Ansprüche 1 bis 3, wobei zwei oder mehr Teiltreiber (20,30) und zwei oder mehr Auswerteschaltungen (50,60) vorgesehen sind, wobei jeder Teiltreiber (20,30) mit einer Auswerteschaltung (50,60) verbunden ist,

5. Treiberschaltung nach Anspruch 4,
wobei zwei oder mehr Rückkopplungskondensatoren (41,42) vorgesehen sind, wobei jeder Rückkopplungskondensator (41,42) zwischen einem Ausgangsknoten (12) der Treiberschaltungen (10) und einem Eingangsknoten (51,61) einer Auswerteschaltung (50,60) vorgesehen ist.

6. Treiberschaltungen nach einem der Ansprüche 1 bis 5,
wobei der/die Eingangsknoten (51,61) der Auswerteschaltung(en) (50,60) niederimpedant ist.

7. Treiberschaltung nach einem der Ansprüche 1 bis 6, wobei der wenigstens eine Teiltreiber (20,30) einen oder mehrere Transistoren (21,22,23,31,32,33) aufweist.

8. Treiberschaltung nach einem der Ansprüche 1 'bis 7,
wobei in dem wenigstens einen Teiltreiber (20,30) wenigstens ein Steuertransistor (24,34) vorgesehen ist, der jeweils mit einer Auswerteschaltung (50,60) verbunden ist.

9. Treiberschaltung nach einem der Ansprüche 1 bis 8,
wobei der wenigstens eine Rückkopplungskondensator (41,42) als linearer Kondensator ausgebildet ist.

10. Treiberschaltung nach einem der Ansprüche 1 bis 9,
wobei der wenigstens eine Rückkopplungskondensator (41,42) als nicht-linearer Kondensator ausgebildet ist.

11. Treiberschaltung nach Anspruch 10,
wobei der nicht-lineare Kondensator aus wenigstens einem PMOS-Transistor (43) und/oder wenigstens einem NMOS-Transistor (44) gebildet ist.

12. Verfahren, bei dem eine Treiberschaltung nach einem der Ansprüche 1 bis 11 betrieben wird,
wobei in der Treiberschaltung ein oberwellenarmer Strom erzeugt und an eine Last geliefert wird und wobei in der Treiberschaltung eine von der aktuellen Lastsituation unabhängige Flankensteilheit eingestellt wird.

13. Verfahren nach Anspruch 12,
wobei ein sin2-förmiger Strom an die Last geliefert wird.

14. Verfahren nach Anspruch 12 oder 13,
wobei zur Einstellung der lastunabhängigen Flankensteilheit die Ausgangscharakteristik der Treiberschaltung von der Rückkopplungsschaltung gemessen und in dieser ausgewertet wird, und wobei die Treiberstärke des wenigstens einen Teiltreibers aufgrund der Auswertungsergebnisse geregelt wird.

15. Verfahren nach Anspruch 14,
wobei die aktuelle Flankensteilheit von dem wenigstens einen Rückkopplungskondensator gemessen wird, wobei der gemessene Wert in die wenigstens eine Auswerteschaltung eingekoppelt und ausgewertet wird, wobei in der Auswerteschaltung ein Ausgangssignal erzeugt wird und wobei über das Ausgangssignal wenigstens ein Regeltransistor gesteuert wird, der zur Regelung der Treiberstärke in dem wenigstens einen Teiltreiber vorgesehen ist.

16. Verwendung einer Treiberschaltung nach einem der Ansprüche 1 bis II und/oder eines Verfahrens nach einem der Ansprüche 12 bis 15 zur Verbesserung der elektromagnetischen Verträglichkeit von elektronischen Bauelementen, insbesondere von integrierten Schaltungen.

## Claims

1. Driver circuit, having at least one input node (11) for an input signal and at least one output node (12) for an output signal, having one or more preferably two, sub-drivers (20, 30) and having a feedback circuit (40), which has one or more evaluation circuits (50, 60) and one or more feedback capacitors (41, 42), the evaluation circuit(s) (50, 60) being connected to the sub-driver(s) (20, 30) and the feedback capacitor(s) (41, 42) respectively being provided between an output node (12) of the driver circuit (10) and an input node (51, 61) of an evaluation circuit (50, 60), the at least one evaluation circuit (50, 60) having a first inverter stage (53, 54), coupled to the input node (51, 61) of the evaluation circuit (50, 60), and also a second inverter stage (56, 57), connected in series with the first inverter stage (53, 54), the first inverter stage (53, 54) being short-circuited with the input node (51, 61).

2. Driver circuit according to Claim 1,
wherein
the at least one input node (11) for the input signal is connected to the at least one sub-driver (20, 30).

3. Driver circuit according to Claim 1 or 2,
wherein
the at least one input node (11) for the input signal is connected to the at least one evaluation circuit (50, 60).

4. Driver circuit according to one of Claims 1 to 3,
wherein
two or more sub-drivers (20, 30) and two or more evaluation circuits (50, 60) are provided, each sub-driver (20, 30) being connected to an evaluation circuit (50, 60).

5. Driver circuit according to Claim 4,
wherein
two or more feedback capacitors (41, 42) are provided, each feedback capacitor (41, 42) being provided between an output node (12) of the driver circuit (10) and an input node (51, 61) of an evaluation circuit (50, 60).

6. Driver circuit according to one of Claims 1 to 5,
wherein
the input node(s) (51, 61) of the evaluation circuit(s) (50, 60) is/are at low impedance.

7. Driver circuit according to one of Claims 1 to 6,
wherein
the at least one sub-driver (20; 30) has one or more transistors (21, 22, 23; 31, 32, 33).

8. Driver circuit according to one of Claims 1 to 7,
wherein
at least one control transistor (24, 34) is provided in the at least one sub-driver (20, 30), said transistor being respectively connected to an evaluation circuit (50; 60).

9. Driver circuit according to one of Claims 1 to 8,
wherein
the at least one feedback capacitor (41, 42) is designed as a linear capacitor.

10. Driver circuit according to one of Claims 1 to 9,
wherein
the at least one feedback capacitor (41, 42) is designed as a nonlinear capacitor.

11. Driver circuit according to Claim 10,
wherein
the nonlinear capacitor is formed from at least one PMOS transistor (43) and/or at least one NMOS transistor (44).

12. Method in which a driver circuit according to one of Claims 1 to 11 is operated,
wherein
a low-harmonics current is generated in the driver circuit and supplied to a load, and wherein an edge steepness that is independent of the present load situation is set in the driver circuit.

13. Method according to Claim 12,
wherein
a sin²-shaped current is supplied to the load.

14. Method according to Claim 12 or 13,
wherein,
in order to set the load-independent edge steepness, the output characteristic of the driver circuit is measured by the feedback circuit and evaluated therein, and wherein the driver strength of the at least one sub-driver is regulated on the basis of the evaluation results.

15. Method according to Claim 14,
wherein
the present edge steepness is measured by the at least one feedback capacitor, wherein the measured value is coupled into the at least one evaluation circuit and evaluated, wherein an output signal is generated in the evaluation circuit, and wherein the output signal controls at least one regulating transistor provided for regulating the driver strength in the at least one sub-driver.

16. Use of a driver circuit according to one of Claims 1 to 11 and/or of a method according to one of Claims 12 to 15 for improving the electromagnetic compatibility of electronic components, in particular of integrated circuits.

## Revendications

1. Circuit d'attaque comportant au moins un noeud d'entrée (11) pour un signal d'entrée et au moins un noeud de sortie (12) pour un signal de sortie comportant un ou plusieurs et de préférence deux étages d'attaque partiels (20, 30) et un circuit de rétroaction (40), qui comporte un ou plusieurs circuits d'évaluation (50, 60) et un ou plusieurs condensateurs de rétroaction (41, 42), dans lequel le ou les circuits d'évaluation (50, 60) est ou sont reliés à ou aux étages d'attaque partiels (20, 30) et dans lequel le ou les condensateurs de rétroaction (41, 42) est ou sont prévus respectivement entre un noeud de sortie (12) du circuit d'attaque (10) et un noeud d'entrée (51, 61) du circuit d'évaluation (50, 60), et dans lequel le au moins un circuit d'évaluation (50, 60) comporte un premier étage inverseur (53, 54), couplé au noeud d'entrée (51, 61) du circuit d'évaluation (50, 60), ainsi qu'un second étage inverseur (56, 57) branché en série avec le premier étage inverseur (53, 54), le premier étage inverseur (53, 54) étant court-circuité avec le noeud d'entrée (51, 61).

2. Circuit d'attaque selon la revendication 1, dans lequel le au moins un noeud d'entrée (11) pour le signal d'entrée est relié à au moins un étage d'attaque partiel (20, 30).

3. Circuit d'attaque selon la revendication 1 ou 2, dans lequel le au moins un noeud d'entrée (11) pour le signal d'entrée est relié à au moins un circuit d'évaluation (50, 60).

4. Circuit d'attaque selon l'une des revendications 1 à 3, dans lequel deux ou plus de deux étages d'attaque partiels (20, 30) et deux ou plus de deux circuits d'évaluation (50, 60) sont prévus, chaque étage d'attaque partiel (20, 30) étant relié à un circuit d'évaluation (50, 60).

5. Circuit d'attaque selon la revendication 4, dans lequel deux ou plus de deux condensateurs de rétroaction (41, 42) sont prévus, chaque condensateur de rétroaction (41, 42) étant prévu entre un noeud de sortie (12) des circuits d'attaque (10) et un noeud d'entrée (51, 61) d'un circuit d'évaluation (50, 60).

6. Circuit d'attaque selon l'une des revendications 1 à 5, dans lequel le ou les noeuds d'entrée (51, 61) du ou des circuits d'évaluation (50, 60) présentent une faible impédance.

7. Circuit d'attaque selon l'une des revendications 1 à 6, dans lequel le au moins un étage d'attaque (20, 30) comporte un ou plusieurs transistors (21, 22, 23, 31, 32, 33).

8. Circuit d'attaque selon l'une des revendications 1 à 7, dans lequel dans au moins un étage d'attaque partiel (20, 30) est prévu au moins un transistor de commande (24, 34), qui est relié respectivement à un circuit d'évaluation (50, 60).

9. Circuit d'attaque selon l'une des revendications 1 à 8, dans lequel le au moins un condensateur de rétroaction (41, 42) est agencé sous la forme d'un condensateur linéaire.

10. Circuit d'attaque selon l'une des revendications 1 à 9, dans lequel le au moins un condensateur de rétroaction (41, 42) est agencé sous la forme d'un condensateur non linéaire.

11. Circuit d'attaque selon la revendication 10, dans lequel le condensateur non linéaire est constitué par au moins un transistor PMOS (43) et/ou au moins un transistor NMOS (44).

12. Procédé, selon lequel on fait fonctionner un circuit d'attaque selon l'une des revendications 1 à 11, et selon lequel un courant présentant peu d'harmoniques supérieurs est produit dans le circuit d'attaque et est appliqué à une charge, et selon lequel une pente de flanc, qui est indépendant de la situation actuelle de la charge, est réglée dans le circuit d'attaque.

13. Procédé selon la revendication 12, selon lequel un courant en forme de sin2 est délivré à la charge.

14. Procédé selon la revendication 12 ou 13, selon lequel pour le réglage de la pente de flanc indépendante de la charge, la caractéristique de sortie du circuit d'attaque est mesurée par le circuit de rétroaction et est évaluée dans ce dernier, et selon lequel la puissance du au moins un étage d'attaque est réglée sur la base des résultats d'évaluation.

15. Procédé selon la revendication 14, selon lequel la pente actuelle de flanc du au moins un condensateur de rétroaction est mesurée, la valeur mesurée étant injectée et évaluée dans le au moins un circuit d'évaluation, et selon lequel un signal de sortie est produit dans le circuit d'évaluation et selon lequel au moins un transistor de régulation est commandé pour régler la puissance du au moins un étage d'attaque, au moyen du signal de sortie.

16. Utilisation d'un circuit d'attaque selon l'une des revendications 1 à 11 et/ou utilisation d'un procédé selon l'une des revendications 12 à 15, pour améliorer la compatibilité électromagnétique de composants électroniques, notamment de circuits intégrés.
